(19) Europäisches Patentamt / European Patent Office / Office européen des brevets

(11) **EP 4 443 520 A1**

(12) **EUROPEAN PATENT APPLICATION**
published in accordance with Art. 153(4) EPC

(43) Date of publication:
**09.10.2024 Bulletin 2024/41**

(21) Application number: **22898176.7**

(22) Date of filing: **10.08.2022**

(51) International Patent Classification (IPC):
**H01L 29/786** (2006.01)   **H01L 21/336** (2006.01)
**H01L 29/16** (2006.01)   **H10K 10/00** (2023.01)
**H10K 85/00** (2023.01)

(52) Cooperative Patent Classification (CPC):
**C01B 32/168; C01B 32/174; H01L 21/304;
H01L 29/16; H01L 29/66477; H01L 29/786;
H10K 10/40; H10K 85/00; H10K 85/20**

(86) International application number:
**PCT/JP2022/030645**

(87) International publication number:
**WO 2023/095391 (01.06.2023 Gazette 2023/22)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.11.2021 JP 2021193569**

(71) Applicant: **Kao Corporation
Tokyo 103-8210 (JP)**

(72) Inventor: **ASAI Mitsuo
Wakayama-shi, Wakayama 640-8580 (JP)**

(74) Representative: **Hoffmann Eitle
Patent- und Rechtsanwälte PartmbB
Arabellastraße 30
81925 München (DE)**

(54) **SEMICONDUCTOR ELEMENT**

(57) The present disclosure relates to a semiconductor element 1 including: a gate electrode 2; a source electrode 3; a drain electrode 4; a semiconductor layer 5 that is in contact with the source electrode 3 and the drain electrode 4; and a gate insulating layer 6 that insulates the semiconductor layer 5 from the gate electrode 2, in which the semiconductor layer 5 has a network structure of carbon nanotubes, the semiconductor layer 5 is sealed with a sealing layer 8, and the semiconductor layer 5 has an average thickness of 5 nm or less. The sealing layer 8 preferably contains a compound whose SP value calculated using the Fedors method is 15 $(cal/cm^3)^{1/2}$ or less. Also, the sealing layer preferably has a relative permittivity of 5.0 or less. The sealing layer 8 preferably contains one or more selected from the group consisting of a fluorine-based resin, an acrylic resin, a styrene-based resin, a vinyl-based resin, and an olefin-based resin.

FIG. 1

**Description**

Technical Field

The present disclosure relates to a semiconductor element, a method for manufacturing the semiconductor element, and the like.

Background Art

In recent years, due to the spread of IoT (Internet of Things) throughout society, various things are connected to the Internet, and there is demand for a wide variety of semiconductor elements. Various substrates are used in these various semiconductor elements, and, for example, flexible semiconductor elements produced using flexible substrates, and semiconductor elements that can be manufactured using materials that can be used in simple processes such as printing have been actively studied.

Carbon nanotubes (CNTs) have high field-effect mobility and high chemical stability. Also, CNTs are materials that can be dispersed in a solution and thus can be used in simple processes. Therefore, CNTs can be applied to or formed into films on various substrates. Thus, CNTs are examples of a candidate material for forming a semiconductor layer, and semiconductor elements produced using CNTs have been actively studied. Specifically, research on CNT filed-effect transistors (CNT-FETs) in which CNTs are used as channels has been actively conducted.

WO 2019/066074 (Patent Document 1) discloses that CNT ink is dropped into a channel layer formation region present between a source electrode and a drain electrode, the ink is dried, and thus a channel layer made of CNTs is formed between the source electrode and the drain electrode. JP 2008-71898A (Patent Document 2) discloses that a dispersion solution in which CNT bundles are dispersed in an organic solvent is dropped between a source electrode and a drain electrode, and the dropped dispersion solution is heated to form a channel portion. Patent Document 3 discloses a method for manufacturing a field-effect transistor, the method including a step of forming a coating film by applying a CNT dispersion liquid containing, as a polymer dispersant, polysaccharide, arabinogalactan, or gum arabic, and forming a semiconductor layer by drying the coating film. In the manufacturing method disclosed in JP 2008-53607A (Patent Document 3), the dried coating film, that is, the semiconductor layer, is preferably subjected to cleaning treatment in order to improve the on/off ratio.

Appl. Master. Interface, 2014, 6, 8441. (Non-Patent Document 1) discloses that a semiconductor layer constituted by a dense and non-uniform random network made of CNTs is covered with a fluorine-based resin in order to reduce hysteresis. Nano Lett., 2003, 3, 193. (Non-Patent Document 2) discloses that a single independent CNT is used as a channel and a semiconductor element is sealed with PMMA (poly(methyl methacrylate)).

Disclosure of Invention

In one aspect, the present disclosure relates to a semiconductor element including: a gate electrode; a source electrode; a drain electrode; a semiconductor layer that is in contact with the source electrode and the drain electrode; and a gate insulating layer that insulates the semiconductor layer from the gate electrode, in which the semiconductor layer has a network structure of carbon nanotubes, the semiconductor layer is sealed with a sealing layer, and the semiconductor layer has an average thickness of 5 nm or less.

The present disclosure relates to a method for manufacturing a semiconductor element according to one aspect of the present disclosure, the semiconductor element including a gate electrode, a source electrode, a drain electrode, a semiconductor layer that is in contact with the source electrode and the drain electrode, and a gate insulating layer that insulates the semiconductor layer from the gate electrode, the method including: forming, using a carbon nanotube dispersion liquid, a semiconductor layer having a network structure of carbon nanotubes and having an average thickness of 5 nm or less; and forming a sealing layer that seals the semiconductor layer.

Brief Description of Drawings

[FIG. 1] FIG. 1 is a schematic perspective view of a semiconductor element according to one aspect of the present disclosure.

[FIG. 2] FIG. 2 is a schematic cross-sectional view of the semiconductor element shown in FIG. 1 taken along line I-I.

[FIG. 3] FIG. 3 is a schematic diagram illustrating a network structure of carbon nanotubes that constitute the semiconductor element according to one aspect of the present disclosure.

[FIG. 4] FIG. 4 is a schematic cross-sectional view of a semiconductor element according to another aspect of the present disclosure.

[FIG. 5] FIGS. 5A to 5C show process diagrams of a method for manufacturing a semiconductor element according to one aspect of the present disclosure.

[FIG. 6] FIGS. 6A to 6C show process diagrams of a method for manufacturing a semiconductor element according to one aspect of the present disclosure.

[FIG. 7] FIG. 7 is an atomic force microscope (AFM) image of a semiconductor layer that constitutes a semiconductor element according to Example 1.

[FIG. 8] FIG. 8 is a schematic diagram illustrating a network structure of carbon nanotubes that constitute a conventional semiconductor element.

Description of the Invention

Because the performance of a semiconductor element greatly influences the performance of a device in which the semiconductor element is to be used, there is demand for semiconductor elements having higher performance and specifically having a small hysteresis.

The semiconductor elements disclosed in Patent Documents 1 to 3 operate in a state in which a channel layer or a semiconductor layer is exposed to an atmosphere, and thus have a problem of large hysteresis.

The hysteresis of the semiconductor element disclosed in Non-Patent Document 2 is significantly reduced by sealing the semiconductor element with PMMA. However, only one nano-sized CNT is used, and thus only a small amount of electric current can flow, and mass production is also difficult with a current technique.

The hysteresis of the semiconductor element disclosed in Non-Patent Document 1 is reduced by sealing the semiconductor layer with a fluorine-based resin. However, because the semiconductor layer is sealed, the ON/OFF ratio of the semiconductor element is worse than that without sealing, to about $10^4$, which is insufficient for practical use.

As described above, when attempts are made to reduce hysteresis using a conventional technique, the ON/OFF ratio decreases, and conventionally, there has been a trade-off relationship between a small hysteresis and a large ON/OFF ratio.

In one aspect, the present disclosure provides a semiconductor element having a small hysteresis and a large ON/OFF ratio, in which CNTs are used, and a method for manufacturing the same.

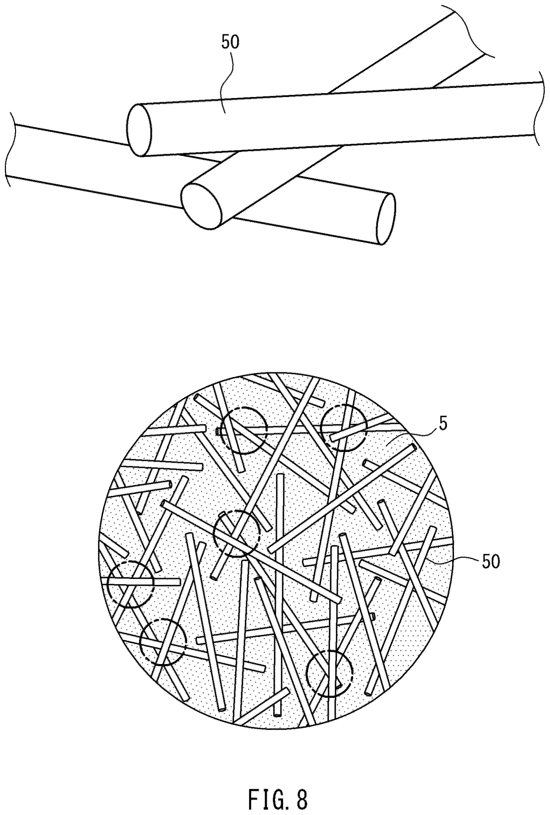

CNTs have a thin cylindrical shape formed by rounding a graphene sheet into a tubular shape. The network structure of CNTs is a structure in which adjacent CNTs are interwined with each other and connected in a network over a wide area. However, the density of CNTs in the thickness direction of the network structure is high, and, for example, as shown in FIG. 8, in the network structure, there are many portions where one or more CNTs are stacked on or below intersection points where two CNTs intersect and in the vicinities thereof. When the CNT network structure is a multilayer structure in which multiple "substantially single-layered CNT films" are stacked, a sufficient gate voltage will not be applied to CNTs located relatively far from the gate electrode. Therefore, it is presumed that an OFF current does not sufficiently decrease, and as a result, the ON/OFF ratio deteriorates (decreases).

Also, it is conceivable that covering of the semiconductor layer with a sealing layer is effective in limiting the exposure of the semiconductor layer having the CNT network structure to an atmosphere, from the viewpoint of reducing hysteresis. However, if the CNT network structure is the multilayer structure, the materials of the sealing layer enter between layers during the manufacturing process. Therefore, it is presumed that a gate voltage is less likely to be applied to CNTs located relatively far from the gate electrode, resulting in further deterioration of the ON/OFF ratio.

As described above, with conventional techniques, there has been a trade-off relationship between a small hysteresis and a large ON/OFF ratio. It was found in the present disclosure that, by making the CNT network structure substantially a single layer and then forming a sealing layer for eliminating contact between the semiconductor layer and the atmosphere, hysteresis can be reduced while a large ON/OFF ratio is being maintained. When the semiconductor layer has an average thickness of 5 nm or less, it is confirmed that the CNT network structure is substantially single-layered. In this specification, a substantially single-layered CNT network structure may be referred to as a "substantially single-layered CNT film".

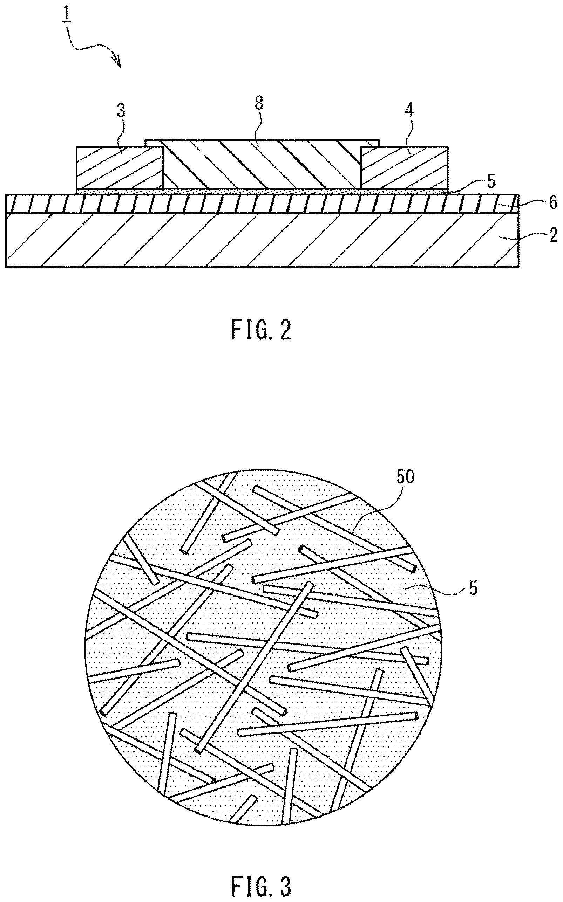

As shown in FIG. 3, the substantially single-layered CNT film preferably has a CNT network structure in which two CNTs 50 substantially intersect each other and are connected in a planar direction in a network by repeats of the intersection. The substantially single-layered CNT film preferably has substantially no portion where three or more CNTs are stacked in a thickness direction (a direction orthogonal to the surface of a semiconductor layer 5), more preferably has almost no portion described above, and even more preferably has no portion described above. It can be confirmed through cross-sectional observation using an atomic force microscope (AFM) that the semiconductor layer is a substantially single-layered CNT film.

According to the present disclosure, it is possible to provide a semiconductor element having a small hysteresis and a large ON/OFF ratio, in which CNTs are used.

Hereinafter, a semiconductor element according to one aspect of the present disclosure will be described with reference to the drawings.

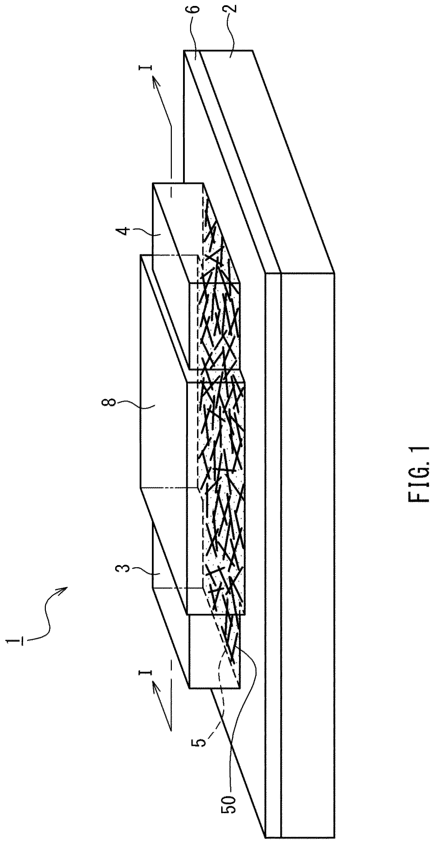

As shown in FIGS. 1 and 2, in one aspect, the semiconductor element according to the present disclosure is a CNT-field-effect transistor (CNT-FET), and is preferably a p-type CNT-field-effect transistor. A semiconductor element 1 includes a gate electrode 2, a source electrode 3, a drain electrode 4, and a semiconductor layer 5. A gate insulating layer 6 is disposed between the semiconductor layer 5 and the gate electrode 2, and the gate insulating layer 6 insulates the semiconductor layer 5 from the gate electrode 2. The source electrode 3 and the drain electrode 4 are formed on a surface of the semiconductor layer 5 opposite to the gate insulating layer 6 side at a predetermined interval (a channel length). A portion (a channel region) of the semiconductor layer 5 located between the source electrode 3 and the drain electrode 4 is covered with a sealing layer 8 in order to prevent the semiconductor layer 5 from coming into contact with an atmosphere. In the semiconductor element 1, the semiconductor layer 5 has a CNT network structure that can be easily manufactured and through which a large amount of current can flow.

Semiconductor layer

The semiconductor layer 5 is constituted by a CNT network structure. In the present disclosure, the network structure refers to a structure in which CNTs in the semiconductor layer are not oriented in a specific direction, and one CNT preferably intersects five or more other CNTs. The longitudinal directions of the CNTs are randomly oriented in two dimensions, and thus the CNTs are not oriented in one direction but are scattered in all directions. Because the CNTs have such a network structure, a large current can flow through the semiconductor layer, and because the CNTs are not oriented in a specific direction, conductivity is not anisotropic. Furthermore, in the network structure, instead of one CNT connecting the source electrode to the drain electrode, a plurality of CNTs form a conductive path between the source electrode and the drain electrode. Therefore, even when a small amount of metallic CNTs are mixed in, it is possible to obtain a good ON/OFF ratio without short circuiting the source electrode and the drain electrode.

In the present disclosure, the CNT network structure is a substantially single-layered CNT film. From the viewpoint of reducing hysteresis and improving the ON/OFF ratio, the average thickness of the semiconductor layer 5 is 5 nm or less, preferably 4 nm or less, and even more preferably 3 nm or less. From the viewpoint of ensuring a sufficient amount of current, the average thickness of the semiconductor layer 5 is preferably 0.1 nm or more, and more preferably 0.3 nm or more. In the present disclosure, the average thickness of the semiconductor layer 5 can be measured using an atomic force microscope (AFM).

Also, preferably, in order to obtain effects of a substantially single-layered CNT film, the CNTs are in a non-aggregated state and in an unbundled state. A "bundled state" refers to a state in which a plurality of CNTs are attached to each other and bundled together. When such CNTs are used in a semiconductor layer, it will be difficult to apply a voltage to a gate and the ON/OFF ratio will deteriorate, as in a case where multi-layered CNT films are used. A state in which one CNT overlaps other CNTs by 10% or more of the length of the CNT is referred to as a bundled state. Because the diameter of CNTs is about 1 to 2 nm, when a semiconductor layer has an average thickness of 5 nm or less, the semiconductor layer will be substantially bundle-free (that is, in a non-bundled state).

From the viewpoint of obtaining a sufficient drain current, the density of the carbon nanotube network is preferably 100 carbon nanotubes/$\mu$m$^2$ or more. Also, if the density is excessively high, a conductive path will be formed between the source electrode and the drain electrode due to a small amount of metallic CNTs mixed therein, causing short circuiting therebetween. As a result, the ON/OFF ratio decreases. In the present disclosure, from the viewpoint of suppressing a decrease in the ON/OFF ratio, the density is preferably 8000 carbon nanotubes/$\mu$m$^2$ or less.

The CNTs that constitute the semiconductor layer 5 may be only single-walled carbon nanotubes (SWCNTs) formed by rolling up a graphene sheet into one layer, or a mixture of SWCNTs and double-walled carbon nanotubes (DWCNTs) formed by rolling up a graphene sheet into two layers or multi-walled carbon nanotubes (MWCNTs) formed by rolling up a graphene sheet into three or more layers. However, from the viewpoint of reducing a leakage current and ensuring a sufficient ON/OFF ratio, the CNTs that constitute the semiconductor layer 5 are preferably constituted by substantially SWCNTs only, and more preferably constituted by only SWCNTs. Note that these CNTs can be distinguished using a known means, for example, Raman spectroscopy, or the like.

CNTs include metallic CNTs exhibiting metallic properties and semiconducting CNTs exhibiting semiconducting properties, and semiconducting CNTs are preferable as CNTs that constitute the semiconductor layer 5. CNTs may be synthesized using a known synthesis method such as a high pressure carbon monoxide disproportionation method (Hi_Pco method), an improved direct jet pyrolysis synthesis method (e-DIPS method), an arc-discharge method, or a laser ablation method. However, SWCNTs synthesized using these ordinary synthesis methods are a mixture containing metallic SWCNTs and semiconducting SWCNTs at a ratio of about 12, and thus it is preferable to form the semiconductor layer 5 using a CNT dispersion liquid obtained by applying, to the mixture, a technique to increase the content of the semiconducting SWCNTs. The content of the semiconducting CNTs in the CNTs that constitute the semiconductor layer 5 is preferably 70% by mass or more, more preferably 80% by mass or more, even more preferably 90% by mass or more, and further preferably 95% by mass or more.

In the present disclosure, the content of the semiconducting CNTs in the semiconductor layer 5 can be regarded as the ratio of semiconducting CNTs to the total amount of CNTs (the total of the semiconducting CNTs and the metallic CNTs) in the CNT dispersion liquid used to form the semiconductor layer 5. In the present disclosure, the ratios of the semiconducting CNTs in the CNT dispersion liquid and in the semiconductor layer 5 can be calculated, for example, based on the results of Raman spectrum measurement using a Raman spectrophotometer described in Examples.

The average diameter of SWCNTs is preferably 0.5 nm or more, more preferably 0.8 nm or more from the viewpoint of ensuring sufficient field-effect mobility, and is preferably 3 nm or less, and more preferably 2 nm or less from the viewpoint of providing the SWCNTs with an appropriate band gap as a semiconductor, suppressing a leakage current, and ensuring a sufficient ON/OFF ratio. The average diameter of SWCNTs can be calculated by measuring and averaging the diameters of ten or more CNTs using images obtained using a transmission electron microscope.

The average length of SWCNTs is preferably 0.1 $\mu$m or more, more preferably 0.3 $\mu$m or more, and even more preferably 0.5 $\mu$m or more from the viewpoint of reducing CNT intersections and ensuring sufficient mobility. From the viewpoint of reducing a leakage current caused by mixed metallic CNTs and ensuring a sufficient ON/OFF ratio, it is preferable that the average length thereof is shorter than the distance between the source electrode and the drain electrode (channel length) of a semiconductor element, and is more preferably 2/3 or less of the channel length, and even more preferably half the channel length or less. For example, the average length thereof is preferably 100 $\mu$m or less, more preferably 50 $\mu$m or less, even more preferably 20 $\mu$m or less, and further preferably 10 $\mu$m or less. The average length of SWCNTs can be calculated by measuring and averaging the lengths of ten or more CNTs using, for example, images obtained using a transmission electron microscope.

Sealing layer

In the semiconductor element 1 of the present disclosure, in order to make the semiconductor layer 5 waterproof and dustproof, the semiconductor layer 5 is sealed with a sealing layer 8 that prevents the semiconductor layer 5 from coming into contact with outside air. The sealing layer 8 may be constituted by a single layer, or may be constituted by a plurality of stacked layers. Although the sealing layer 8 may be made of a conventionally known material, from the viewpoint of reducing hysteresis, the sealing layer 8 preferably contains a compound whose solubility parameter value (hereinafter also referred to as an "SP value") calculated by the Fedors method using the following formula (1) is 15 or less. From the same viewpoint, the SP value of the material of the sealing layer 8 is more preferably 14 or less, even more preferably 11 or less, and further preferably 9 or less. Also, from the viewpoint of availability, the SP value thereof is preferably 3 or more, more preferably 4 or more, and even more preferably 5 or more. The unit of SP value is $(cal/cm^3)^{1/2}$.

$$\delta=[\Sigma E_{coh}/\Sigma V]^{1/2} \qquad (1)$$

where, in the above formula (1), $\Sigma E_{coh}$ indicates cohesive energy and $\Sigma V$ indicates molar molecular volume.

Also, in order not to influence electric properties of the semiconductor element, the lower the relative permittivity of the material of the sealing layer 8 is, the better the sealing layer 8 is, and the relative permittivity thereof is preferably 5.0 or less, and more preferably 4.0 or less. There is no particular limitation on the lower limit of the relative permittivity, and the relative permittivity thereof is usually 1.0 or more. The relative permittivity of a material forming the sealing layer 8 is a value measured using the method described in Examples. In addition, the material of the sealing layer 8 is preferably an electrically inactive compound that does not dope electrons or holes into the semiconductor layer.

A hydrophobic polymer is preferable as a material of the sealing layer 8, and, preferably, specific examples thereof include at least one polymer selected from acrylic resins, styrene-based resins, vinyl-based resins, olefin-based resins, and fluorine-based resins, from the viewpoint of not causing a side reaction with SWCNTs during sealing, and not deteriorating the performance of the semiconductor element.

Examples of the acrylic resins include poly(methyl methacrylate) (PMMA), polybutyl methacrylate, and polycyclohexyl methacrylate, examples of the styrene-based resin include polystyrene (P-St), acrylonitrile-styrene copolymer (AS), and acrylonitrile-butadiene-styrene copolymer (ABS), examples of vinyl-based resins include polyvinyl acetate, polyvinyl chloride (PVC), polyvinyl alcohol (PVA), polyvinyl butyral, and polyvinylpyrrolidone (PVP), examples of the olefin-based resins include polyethylene, polypropylene, cyclic olefin polymer (COP), and cyclic olefin copolymer (COC), and examples of the fluorine-based resins include commercially available products such as CYTOP (registered trademark) CTL-809A (manufactured by AGC Inc.). The material of the sealing layer 8 may be one type of these resin materials or a combination of two or more types. Also, in particular, the material of the sealing layer 8 is preferably one or more polymers selected from polyvinyl alcohol (PVA: SP value is 14.6), polyvinylpyrrolidone (PVP: SP value is 13.4), polyvinyl chloride (PVC: SP value is 11.0), polystyrene (P-St: SP value is 10.5), poly(methyl methacrylate) (PMMA: SP value is 9.9), and CYTOP (registered trademark) CTL-809A (SP value is 8.7, manufactured by AGC Inc.).

The average thickness of the sealing layer 8 (the sum of the average thicknesses of multiple layers when the sealing layer is formed by stacking multiple layers) in a region (a channel region) present between the source electrode 3 and the drain electrode 4 is preferably 200 nm or more, more preferably 500 nm or more, and even more preferably 1000 nm or more, from the viewpoint of ensuring sufficient barrier properties against water, oxygen, and the like, and reducing hysteresis. There is no particular limitation on the upper limit of the average thickness of the sealing layer, and the upper limit thereof is preferably 1 mm or less. In the present disclosure, the average thickness of the sealing layer 8 can be measured using an atomic force microscope (AFM) or a stylus type surface profile measuring device.

Source Electrode and Drain Electrode

The source electrode 3 and the drain electrode 4 are electrically connected to each other through the CNT network structure of the semiconductor layer 5 that functions as a channel. There is no particular limitation on the materials of the source electrode 3 and the drain electrode 4 as long as they are conductive, and examples thereof include metals such as titanium, copper, gold, platinum, chromium, aluminum, palladium, and molybdenum, semiconductors such as polysilicon, and conductive metal oxides such as indium tin oxide (ITO). The source electrode 3 and the drain electrode 4 may have a multilayer structure made of two or more types of metals. Examples of a method for forming these electrodes include conventionally known methods such as vacuum deposition, electron beam, sputtering, plating, CVD, ion plating coating, inkjet, and printing.

A channel length (L) and a channel width (W) may be conventionally known dimensions, and the channel length (L) is, for example, 10 $\mu$m or more and 1000 $\mu$m or less, and the channel width (W) is, for example, 10 $\mu$m or more and 10000 $\mu$m or less. However, the present disclosure is not limited thereto.

Gate Electrode and Gate Insulating Film

The semiconductor element 1 according to one aspect of the present disclosure is a so-called bottom-gate semiconductor element, in which a silicon substrate functions as the gate electrode 2, and a thermal oxide film $SiO_2$ formed on one main surface of the silicon substrate functions as a gate insulating film 6. Also, in the examples shown in FIGS. 1 and 2, the entire one main surface of the silicon substrate is covered with the gate insulating film 6. However, it is sufficient that a region where at least the source electrode 3, the drain electrode 4, and the semiconductor layer 5 are disposed is covered with the gate insulating layer 6.

The gate insulating layer 6 may have a single-layer structure, a multilayer structure, or a partial multilayer structure. From the viewpoint of sufficiently reducing the leakage current at the gate, the total thickness of the gate insulating layer 6 is preferably 10 nm or more, and more preferably 20 nm or more. Also, from the viewpoint of reducing the operation voltage, the total thickness of the gate insulating layer 6 is preferably 500 nm or less, and more preferably 200 nm or less. Examples of the material of the gate insulating layer include inorganic compounds such as silicon oxide, silicon nitride, and hafnium oxide, and organic compounds such as vinylphenol resin, poly(p-xylene), polyvinylidene fluoride, and polyimide.

The semiconductor element according to the present disclosure is not limited to a form in which the silicon substrate functions as the gate electrode 2, and may have a form in which at least a surface on which electrodes are disposed is provided with an insulating substrate, and a gate electrode is disposed on the substrate. The substrate may be made of an inorganic material, examples thereof including a glass substrate, a sapphire substrate, an alumina sintered body, or a silicon wafer, or a substrate obtained by coating a surface thereof with an oxide film, may be a sheet made of polyimide (PI) resin, polyester resin, polyamide resin, epoxy resin, polysulfone resin, polyamide resin, or the like, or may be made of a film-like flexible material such as those mentioned above.

There is no particular limitation on the material of the gate electrode as long as it is conductive, and examples thereof include metals such as gold, platinum, chromium, titanium, and aluminum. The gate electrode is formed through, for example, vapor deposition of such a metal at a desired position. A separately prepared metal thin film may be disposed as a gate electrode at a desired position of the substrate to prepare the gate electrode. Examples of a method for forming these electrodes include conventionally known methods such as vacuum deposition, electron beam, sputtering, plating, CVD, ion plating coating, inkjet, and printing, depending on a material thereof.

The semiconductor element according to the present disclosure can take various forms such as a back gate type, a side gate type, and a top gate type, depending on the position of the gate electrode.

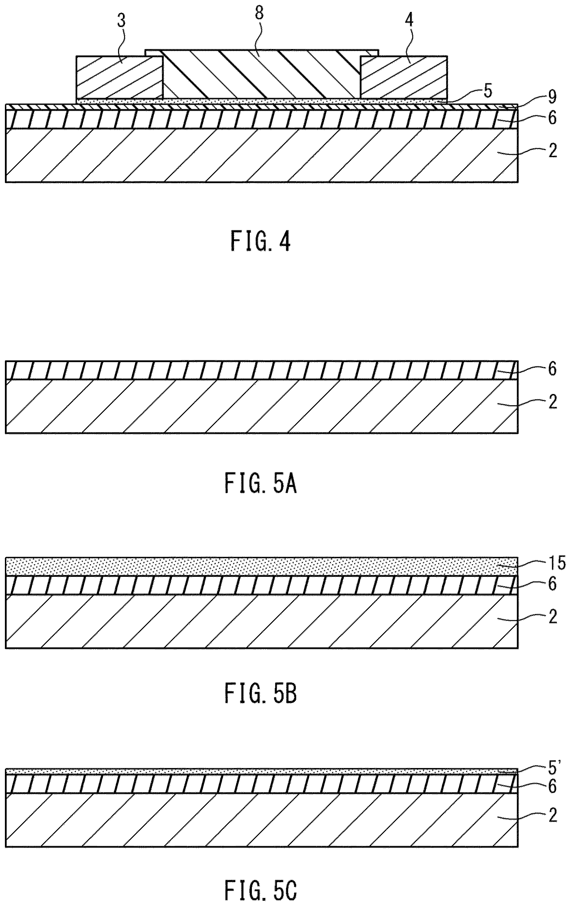

As shown in FIG. 4, preferably, in the semiconductor element according to the present disclosure, from the viewpoint of increasing CNT adsorption, an adsorption layer 9 is formed by treating the surface of the gate insulating layer 6 using a surface treatment agent, and the adsorption layer 9 is disposed between the semiconductor layer 5 and the gate insulating layer 6 and is in contract with the semiconductor layer 5 and the gate insulating layer 6. Compounds having anionic groups cause charge traps when such compounds are present on the gate insulating layer 6, which may increase hysteresis or reduce the ON/OFF ratio. Therefore, the adsorption layer 9 is preferably made of a compound that does not have an anionic group.

The adsorption layer 9 is preferably formed using, for example, a silane coupling agent having no anionic group, such as 3-aminopropyltriethoxysilane (APTES), methyltriethoxysilane (MTES), methyltrimethoxysilane (MTMS), N-2-(aminoethyl)-3-aminopropyltrimethoxysilane, octadecyltrichlorosilane (OTS), fluorine-substituted octatrichlorosilane (PFOTS), or tetracyanoquinodimethane. The adsorption layer 9 may be formed, for example, by applying a solution obtained by dissolving these materials in an organic solvent to the gate insulating layer 6 using a coating method such as a dip coating method, or may be formed using a vapor phase method, or the like.

Method for manufacturing semiconductor element

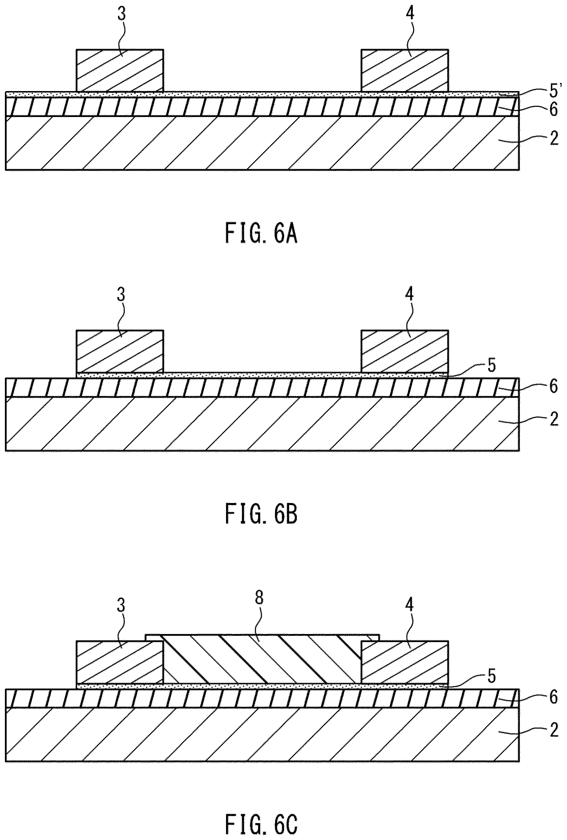

Next, a method for manufacturing the semiconductor element 1 shown in FIGS. 1 and 2 will be described. FIGS. 5A to 5C and FIGS. 6A to 6C are cross-sectional diagrams illustrating a method for manufacturing the semiconductor element 1 in order to processes.

First, as shown in FIG. 5A, the gate electrode 2 whose one main surface is covered with the gate insulating film 6 is prepared. Specifically, a silicon substrate (the gate electrode 2) having a silicon oxide ($SiO_2$) layer (the gate insulating film 6) formed by thermal oxidation of one main surface is prepared.

Then, as shown in FIG. 5B, a coating film 15 is formed by applying a CNT dispersion liquid to the entire surface of the gate insulating film 6 opposite to the gate electrode 2 side. Then, the CNTs are sufficiently adsorbed onto the surface of the gate insulating film 6 by letting the substrate stand still for a while. Thereafter, the thickness of a coating film 15 is reduced by removing excess CNTs from the coating film before drying treatment is performed. Then, as shown in FIG. 5C, a substantially single-layered CNT film is formed as a semiconductor layer 5' by performing drying treatment on the remaining coating film. The CNT dispersion liquid can be applied using a method such as a method for dropping the CNT dispersion liquid using a dispenser, a printing method such as inkjet printing, screen printing, or offset printing, a spin coating method, or a dip coating method. In particular, from the viewpoint of forming a highly homogeneous CNT network structure, a method for dropping a CNT dispersion liquid using a dispenser and a spin coating method are preferable. The CNTs are adsorbed on a surface to be coated with the CNT dispersion liquid (a surface of the gate insulating film 6, or a surface of the adsorption layer 9 when the CNT dispersion liquid is applied to the adsorption layer 9 (see FIG. 4)) through hydrophobic interaction between CNTs and the surface to be coated therewith. Excess CNTs are removed from the coating film 15 before drying treatment is performed, and preferably removed through cleaning treatment, which will be described later. The substantially single-layered CNT film can be formed by adjusting, as appropriate, the thickness of the coating film 15 before cleaning treatment is performed, the concentration of CNTs in the CNT dispersion liquid, the time taken from when the CNT dispersion liquid is applied to when cleaning is performed, or the like.

CNT Dispersion Liquid

The CNT dispersion liquid contains CNTs and a dispersion medium, and if necessary, a CNT dispersant. The concentration of CNTs in the CNT dispersion liquid is preferably 0.1 μg/mL or more, more preferably 0.5 μg/mL or more, and even more preferably 1.0 μg/mL or more from the viewpoint of ensuring a sufficient amount of current, and is preferably 7.0 μg/mL or less, more preferably 5.0 μg/mL or less, and even more preferably 3.0 μg/mL or less from the viewpoint of forming a substantially single-layered homogeneous CNT network structure.

The dispersion medium is preferably an aqueous medium, and the aqueous medium is preferably pure water, ion-exchanged water, purified water, or distilled water, and more preferably pure water. In addition to water, the aqueous medium may contain a lower alcohol such as methanol, ethanol, or isopropyl alcohol, or a water-soluble organic solvent such as acetone, tetrahydrofuran, or dimethylformamide.

According to one aspect of the present disclosure, it is preferable to form the semiconductor layer 5 using a CNT dispersion liquid obtained by, for example, applying, to a mixture of metallic CNTs and semiconducting CNTs, a technique to increase the content of the semiconducting CNTs. In one aspect of the present disclosure, it is preferable to form the semiconductor layer 5 using a semiconducting SWCNT dispersion liquid obtained using the method disclosed in, for example, JP 2021-080121A, JP 2021-080120A, JP 2021-080119A, JP 2019-202912A, or the like. These semiconducting SWCNT dispersion liquids contain, for example, an acrylic acid-based resin as a CNT dispersant. Examples of the acrylic acid-based resin disclosed in these publications include polyacrylic acid, a copolymer of acrylic acid and phenoxydioxyethylene acrylate (PDEA), a copolymer of acrylic acid and methoxydioxypropylene acrylate (MDPA), a copolymer of acrylic acid and polyethylene glycol monoacrylate (the average number of added moles of ethyleneoxy groups is 2 to 10), and homopolymers such as polyethylene glycol monomethacrylate (the number of added moles of ethyleneoxy groups is 2 to 45).

The content of the semiconducting CNTs in the CNTs contained in the semiconducting SWCNT dispersion liquid is preferably 70% by mass or more, more preferably 80% by mass or more, even more preferably 90% by mass or more, and further preferably 95% by mass or more.

From the viewpoint that the CNTs are appropriately adsorbed onto a lower layer, that is, the gate insulating layer 6 or the adsorption layer 9, the standing period of time from immediately after the formation of the coating film 15 until the cleaning treatment for removing excess CNTs is performed is preferably 1 minute or more, more preferably 5 minutes or more, even more preferably 10 minutes or more, and further preferably 30 minutes or more, and from the viewpoint of productivity, is preferably 180 minutes or less, more preferably 120 minutes or less, and even more preferably 90 minutes or less.

Cleaning Treatment

In one aspect, in the method for manufacturing a semiconductor element according to the present disclosure, during formation of the semiconductor layer 5, a coating film is formed by applying the CNT dispersion liquid to a surface to be coated, the CNTs are adsorbed onto the surface to be coated, excess CNTs are removed from the undried coating film, and drying treatment is performed to form the semiconductor layer. Here, "undried" refers to a state before the dispersion medium, which is a constituent component of the CNT dispersion liquid, is completely evaporated, and for example, refers to a state before later-described drying treatment is started.

Excess CNTs are removed from the coating film 15 through, for example, cleaning treatment. When the above standing period of time has passed and the CNTs are appropriately adsorbed onto the lower layer, the cleaning treatment can be performed, for example, by pouring a cleaning liquid onto the coating film 15, or by immersing a stack that includes the coating film 15, the gate insulating layer 6, and the gate electrode 2 in a cleaning liquid in a bath, or the like. From the viewpoint of forming a substantially single-layered CNT film and a homogeneous CNT network structure, it is preferable to use a cleaning method for immersing the stack including the coating film 15 in the cleaning liquid in the bath. In order to avoid removal of CNTs that are adsorbed onto the lower layer and constitute a substantially single-layered CNT film, for example, polar solvents such as ultrapure water, alcohols such as ethanol and methanol, acetone, and tetrahydrofuran (THF) are preferable as the cleaning liquid. The immersion time is preferably 1 minute or more, more preferably 3 minutes or more, even more preferably 5 minutes or more, further preferably 10 minutes or more, and still more preferably 30 minutes or more, and preferably 180 minutes or less, more preferably 120 minutes or less, even more preferably 90 minutes or less, and further preferably 80 minutes or less.

The semiconductor layer 5' is formed by performing drying treatment on the coating film 15 cleaned as described above to volatilize the dispersion medium. The drying treatment is performed by, for example, placing the stack in an atmosphere set at a predetermined temperature. The temperature of the atmosphere is preferably 50°C or more, more preferably 80°C or more, even more preferably 100°C or more, and preferably 250°C or less, more preferably 220°C or less, and even more preferably 200°C or less. The drying time is preferably 5 minute or more, more preferably 10 minutes or more, even more preferably 20 minutes or more, and further more preferably 30 minutes or more, and preferably 240 minutes or less, more preferably 180 minutes or less, even more preferably 120 minutes or less, and further preferably 90 minutes or less.

Then, as shown in FIG. 6A, the source electrode 3 and the drain electrode 4 are formed on the semiconductor layer 5'. The method for forming the source electrode 3 and the drain electrode 4 may be a conventionally known method, and for example, a metal mask is placed on a surface of the semiconductor layer 5' opposite to the gate insulating film 6 side, and metal materials, which will form the source electrode 3 and the drain electrode 4, are each vacuum deposited into openings of the metal mask.

Then, as shown in FIG. 6B, an unnecessary portion of the semiconductor layer 5' is removed through etching, the silicone substrate 2 provided with the source electrode 3 and the drain electrode 4 is then heated at 100°C or more and 200°C or less for 30 minutes or more and 60 minutes or less to remove a trace amount of moisture adsorbed on the gate insulating layer 6 and the semiconductor layer 5, and annealing is performed.

Then, as shown in FIG. 6C, the sealing layer 8 is formed on a portion (a channel region) of the semiconductor layer 5 located between the source electrode 3 and the drain electrode 4. Specifically, for example, the sealing layer 8 is formed by applying a resin solution for forming the sealing layer 8 using a coating method such as spin coating, and then drying the resin solution as needed.

This application further discloses a later-described semiconductor element, a method for manufacturing the same, and the like.

(1) A semiconductor element including:

a gate electrode;
a source electrode;
a drain electrode;
a semiconductor layer that is in contact with the source electrode and the drain electrode; and
a gate insulating layer that insulates the semiconductor layer from the gate electrode,

in which the semiconductor layer has a network structure of carbon nanotubes,
the semiconductor layer is sealed with a sealing layer, and
the semiconductor layer has an average thickness of 5 nm or less.

(2) The semiconductor element according to (1), including a gate electrode, a source electrode, a drain electrode, a semiconductor layer that is in contact with the source electrode and the drain electrode, and a gate insulating layer that insulates the semiconductor layer from the gate electrode,

in which the semiconductor layer has a network structure of single-walled carbon nanotubes,
the semiconductor layer is sealed with a sealing layer having a relative permittivity of 5.0 or less, and
the semiconductor layer has an average thickness of 0.1 nm or more and 5 nm or less.

(3) The semiconductor element according to (1) or (2), including a gate electrode, a source electrode, a drain electrode, a semiconductor layer that is in contact with the source electrode and the drain electrode, and a gate insulating layer that insulates the semiconductor layer from the gate electrode,

in which the semiconductor layer has a network structure of single-walled carbon nanotubes,
the content of semiconducting carbon nanotubes in carbon nanotubes contained in the semiconductor layer is 70% by mass or more,
the semiconductor layer is sealed with a sealing layer containing one or more selected from the group consisting of a fluorine-based resin, an acrylic resin, a styrene-based resin, a vinyl-based resin, and an olefin-based resin,
the sealing layer has an average thickness of 200 nm or more, and
the semiconductor layer has an average thickness of 0.1 nm or more and 5 nm or less.

(4) The semiconductor element according to any one of (1) to (3),
in which the sealing layer contains a compound whose SP value calculated using the Fedors method is 3 $(cal/cm^3)^{1/2}$ or more and 15 $(cal/cm^3)^{1/2}$ or less.

(5) The semiconductor element according to any one of (1) to (4), further including

an adsorption layer that is disposed between the semiconductor layer and the gate insulating film and is in contact with the semiconductor layer and the gate insulating film,
in which the adsorption layer contains a compound that does not have an anionic group.

(6) The semiconductor element according to (5),
in which the adsorption layer is formed using a silane coupling agent that does not have an anionic group.

(7) The semiconductor element according to any one of (1) to (6),
in which a density of carbon nanotubes in the network structure is 100 carbon nanotubes/$\mu$m$^2$ or more and 8000 carbon nanotubes/$\mu$m$^2$ or less.

(8) The semiconductor element according to any one of (1) to (7),
in which an average length of the carbon nanotubes in the network structure is shorter than a channel length of the semiconductor element.

(9) The semiconductor element according to any one of (1) to (8),
in which an average diameter of the carbon nanotubes in the network structure is 0.5 nm or more and 3 nm or less.

(10) A method for manufacturing a semiconductor element
the semiconductor element including a gate electrode, a source electrode, a drain electrode, a semiconductor layer that is in contact with the source electrode and the drain electrode, and a gate insulating layer that insulates the semiconductor layer from the gate electrode, the method including:

forming, using a carbon nanotube dispersion liquid, a semiconductor layer having a network structure of carbon nanotubes and having an average thickness of 5 nm or less; and
forming a sealing layer that seals the semiconductor layer.

(11) The method for manufacturing a semiconductor element according to (10),

the semiconductor element including a gate electrode, a source electrode, a drain electrode, a semiconductor layer that is in contact with the source electrode and the drain electrode, and a gate insulating layer that insulates the semiconductor layer from the gate electrode, the method including:
forming the semiconductor layer by forming a coating film by applying the carbon nanotube dispersion liquid, causing the carbon nanotubes to be adsorbed onto the surface to be coated, removing excess carbon nanotubes from the undried coating film, and performing drying treatment.

(12) The method for manufacturing a semiconductor element according to (11),
in which a concentration of carbon nanotubes in the carbon nanotube dispersion liquid is 0.1 μg/mL or more and 7.0 μg/mL or less.

(13) The method for manufacturing a semiconductor element according to (11) or (12),
in which the excess carbon nanotubes are removed by immersing the coating film in a cleaning liquid.

(14) The method for manufacturing a semiconductor element according to any one of (10) to (13), further including adjusting the carbon nanotube dispersion liquid containing an acrylic acid-based resin.

Examples

Hereinafter, the present disclosure will be described in more detail by way of examples, but these examples are merely exemplary, and the present disclosure is not limited to these examples.

1. Method for Measuring Various Parameters

Measurement of Weight Average Molecular Weight of Polymer

The weight average molecular weight of a polymer used to prepare an SWCNT dispersion liquid was measured through gel permeation chromatography (also referred to as "GPC" hereinafter) under the following conditions.

GPC Conditions

Measurement Apparatus: HLC-8320GPC (manufactured by Tosoh Corporation) Column: $\alpha$-M + $\alpha$-M (manufactured by Tosoh Corporation)
Eluate: Solution of 60 mmol/L $H_3PO_4$ and 50 mmol/L LiBr in N,N-dimethylformamide (DMF)
Flow rate: 1.0 mL/min
Column temperature: 40°C
Detection: RI
Sample size: 0.5 mg/mL
Standard substance: monodisperse polystyrene (manufactured by Tosoh Corporation)

Content of Semiconducting SWCNTs

Raman spectra of SWCNTs before dispersion, and the SWCNT dispersion liquid dried on a slide glass (SWCNTs after dispersion) were measured using a laser Raman microscope (Nanotophoton Corporation "RAMAN touch") at an excitation wavelength of 633 nm. The RBM (Radial Breathing mode) peaks (100 to 350 cm$^{-1}$) of the Raman spectrum excited at 633 nm include a peak unique to the semiconducting SWCNTs and a peak unique to metallic SWCNTs. It is possible to calculate the content of the semiconducting SWCNTs in the SWCNTs after dispersion by calculating the ratio ($A_{s/m}$) of the area $A_s$ of the peak unique to the semiconducting SWCNTs to the area $A_m$ of the peak unique to metallic SWCNTs in the SWCNTs before dispersion, and the ratio ($A_{s/m}'$) of the area $A_s$ of the peak unique to the semiconducting SWCNTs to the area $A_m$ of the peak unique to the metallic SWCNTs in the SWCNT dispersion liquid. The content of the semiconducting SWCNTs in the SWCNT dispersion liquid can be calculated using the following formula based on the semiconductor content of 67% by mass to the SWCNTs before dispersion.

$$\text{Content of semiconducting SWCNTs} =$$

$$[(0.67/A_{s/m}) \times A_{s/m}' \times 100]/[0.33 + (0.67/A_{s/m}) \times A_{s/m}']$$

Measurement of Average Diameter and Average Length of SWCNTs

The average diameter and the average length of SWCNTs were calculated by respectively measuring and averaging the diameters and the lengths of ten or more CNTs using images obtained using a transmission electron microscope.

Measurement of Average Thickness of Semiconductor Layer

The average thickness of the semiconductor layer was measured by using an atomic force microscope (AFM), measuring the height from the surface of the thermal oxide film ($SiO_2$) to the surface of the semiconductor layer at five desired positions, and averaging the obtained values.

Measurement of Density of Carbon Nanotubes in Carbon Nanotube Network

An image of the region (the channel region) of the semiconductor layer between the source electrode and the drain electrode was obtained using an atomic force microscope, and a value obtained by squaring the number of CNTs present on one side of a 1 $\mu$m-square of the image squared was measured as the density of carbon nanotubes (carbon nanotubes/$\mu m^2$).

Average Thickness of Sealing Layer

The average thickness of the sealing layer was measured by, using a stylus type surface profile measuring device, measuring the height from the surface of the semiconductor layer to the surface of the sealing layer at five desired positions between the source electrode and the drain electrode, and averaging the obtained values.

Relative Permittivity of Sealing Layer

The relative permittivity of the sealing layer was measured by molding a resin used for the sealing layer into a film and using a capacitance method with an impedance analyzer at 25°C and 1 MHz.

Measurement of Semiconductor Element

Current transfer properties of the semiconductor element were measured in an atmosphere. The drain current (Ids) obtained when the gate voltage (Vgs) was varied was measured using a semiconductor property evaluation apparatus (manufactured by KEITHLEY Instruments). The drain voltage (Vds) was set to -1 V, and the gate voltage (Vgs) was swept back and forth between 20 V and -20 V At this time, the ON/OFF ratio was determined using the maximum value and the minimum value of the drain current (Ids). Also, hysteresis was calculated using the absolute value |Vgs1-Vgs2 | of a gate voltage difference between the gate voltage of the forward sweep (Vgs1) and the gate voltage of the reverse sweep (Vgs2) when the drain current (Ids) = -100 nA. The results therefor are shown in Table 1 below

Production of CNT Dispersion Liquid

A 0.5 wt.% PEG (9) MA aqueous solution was obtained by dissolving, in pure water, a polymer (the weight average molecular weight was 100,000) synthesized using the method disclosed in JP 2021-80120A using, as a raw material monomer, polyethylene glycol (9) monomethacrylate (PEG (9) MA, "MG-90G" manufactured by Shin-Nakamura Chemical Co., Ltd., the number of added moles of polyoxyethylene was 9). A liquid mixture was obtained by adding 30 mg of SWCNTs ("HiPco-Raw" manufactured by NanoIntegris, the average diameter was 1.0 nm, and the average length was 0.5 $\mu$m) to 30 g of the 0.5 wt.% PEG (9) MA aqueous solution.

Then, the SWCNTs were dispersed for 10 minutes using an ultrasonic homogenizer ("450D" manufactured by Branson) under conditions where the power output was 30% and the liquid temperature was 10°C while the mixture was being stirred using a stirrer. Thereafter, the dispersed solution was centrifuged using an ultracentrifuge ("CX100GXII" with rotor S50 manufactured by Hitachi KoKi Co., Ltd.) for 60 minutes under the conditions where the rotational speed was 50000 rpm and the liquid temperature was 20°C. A CNT dispersion liquid in which the ratio of semiconducting CNTs (the content of semiconducting CNTs) to the total amount of CNTs (the total of semiconducting CNTs and metallic CNTs) was 98 wt.% was obtained by collecting 80% of the supernatant liquid from the liquid surface on a volume basis.

Note that SWCNTs used had a peak unique to metallic SWCNTs around 100 to 220 $cm^{-1}$ and a peak unique to semiconducting SWCNTs around 220 to 350 $cm^{-1}$.

Example 1

An adsorption layer made of 3-aminopropyltriethoxysilane (APTES) was formed using a vapor phase method on a silicon substrate having an area of 1 $cm^2$ (the area of a main surface) on which a thermal oxide film ($SiO_2$) having a thickness of 200 nm was deposited. Then, the CNT dispersion liquid obtained using the above method was diluted with pure water to adjust the concentration to 1.45 $\mu$g/mL based on the mass of CNTs, and the resulting CNT dispersion liquid was then applied to the entire surface of the adsorption layer to form a coating film, and then the substrate was left at room temperature for 1 hour. Thereafter, before drying treatment was performed, an excess CNTs were removed by immersing, in ultrapure water for 60 minutes, the silicon substrate on which the coating film was formed, and then the silicone substrate was pulled out of the ultrapure water and dried in an atmosphere at 180°C for 60 minutes to obtain a semiconductor layer having an average thickness of 2 nm. Based on the AFM images, the network density of carbon nanotubes in the semiconductor layer was 625 carbon nanotubes/$\mu$m$^2$. Also, the observation of the image of the 1 $\mu$m square of the region (the channel region) of the semiconductor layer between the source electrode and the drain electrode using the atomic force microscope revealed that the longitudinal directions of CNTs were randomly oriented in two dimensions, and one CNT intersected five or more other CNTs. Also, regarding all of the CNTs observed in the 1 $\mu$m square, the total length of portions that overlapped (intersected) other CNTs in the longitudinal direction of the CNTs was 3%. Then, a source electrode and a drain electrode that each had a two-layer structure (Ti/Au) were each formed through vacuum deposition such that the channel length (L) was 100 $\mu$m and the channel width (W) was 1000 $\mu$m, and the Ti layer had a thickness of 5 nm and the Au layer deposited on the Ti layer had a thickness of 100 nm through a metal mask. The substrate on which the source electrode and the drain electrode were formed was heated at 180°C for 1 hour. An excess semiconductor layer was removed through etching, and then, a sealing layer having an average thickness of 500 nm was formed by applying a chloroform solution containing 1 wt.% polystyrene (manufactured by Aldrich) through spin coating (2000 rpm, 30 s). The semiconductor element shown in FIG. 1 was produced in this manner.

Example 2

A semiconductor element was produced in the same manner as in Example 1, except that a sealing layer having an average thickness of 1200 nm was formed through spin coating (first step: 500 rpm and 5 s, and second step: 2000 rpm and 20 s) using a CT-Solv. 180 solution containing 9 wt.% fluoropolymer (CYTOP (registered trademark), CTL-809A manufactured by AGC), instead of the chloroform solution containing 1 wt.% polystyrene, and then heating the solution at 180°C for 60 minutes.

Example 3

A semiconductor element was produced in the same manner as in Example 2, except that a sealing layer having an average thickness of 500 nm was formed through spin coating (first step: 500 rpm and 5 s, and second step: 3000 rpm and 20 s), and then heating the solution at 180°C for 60 minutes.

Example 4

A semiconductor element was produced in the same manner as in Example 1, except that a sealing layer having an average thickness of 500 nm was formed using a chloroform solution containing 1 wt.% polymethyl methacrylate, instead of the chloroform solution containing 1 wt.% polystyrene.

Example 5

A semiconductor element was produced in the same manner as in Example 1, except that methyltrimethoxysilane (MTMS) was used instead of APTES as a material of an adsorption layer.

Example 6

A semiconductor element was produced in the same manner as in Example 2, except that an isopropanol solution containing 1 wt.% N-2-(aminoethyl)-3-aminopropyltrimethoxysilane (KBM-603 manufactured by Shin-Etsu Chemical Co., Ltd.) was used instead of APTES as a material of an adsorption layer.

Example 7

A semiconductor element was produced in the same manner as in Example 1, except that a sealing layer having an average thickness of 500 nm was formed using an acetone solution containing 1 wt.% polyvinyl chloride, instead of the chloroform solution containing 1 wt.% polystyrene.

Example 8

A semiconductor element was produced in the same manner as in Example 1, except that a sealing layer having an average thickness of 500 nm was formed using an acetone solution containing 1 wt.% polyvinylpyrrolidone, instead of the chloroform solution containing 1 wt.% polystyrene.

Example 9

A semiconductor element was produced in the same manner as in Example 1, except that a sealing layer having an average thickness of 500 nm was formed through spin coating (2000 rpm and 30 s) using an aqueous solution containing 1 wt.% polyvinyl alcohol, instead of the chloroform solution containing 1 wt.% polystyrene, and then heating the solution at 100°C for 60 minutes.

Comparative Example 1

A semiconductor element was produced in the same manner as in Example 1, except that a CNT dispersion liquid with a CNT concentration of 7.5 $\mu$g/mL was used instead of a CNT dispersion liquid with a CNT concentration of 1.45 $\mu$g/mL, and formation of a sealing layer was omitted. Based on the AFM images, the network density of carbon nanotubes in the semiconductor layer was 10000 carbon nanotubes/$\mu$m$^2$.

Comparative Example 2

A semiconductor element was produced in the same manner as in Example 2, except that a CNT dispersion liquid with a CNT concentration of 7.5 $\mu$g/mL was used instead of a CNT dispersion liquid with a CNT concentration of 1.45 $\mu$g/mL.

Comparative Example 3

A semiconductor element was produced in the same manner as in Example 1, except that a CNT dispersion liquid with a CNT concentration of 7.5 $\mu$g/mL was used instead of a CNT dispersion liquid with a CNT concentration of 1.45 $\mu$g/mL.

Comparative Example 4

A semiconductor element was produced in the same manner as in Example 1, except that formation of a sealing layer was omitted.

Table 1

| Table 1 | Configuration of Semiconductor Element | | | | | | Performance Evaluation | |
|---|---|---|---|---|---|---|---|---|
| | Average Thickness of Semiconductor Layer (nm) | Adsorption Layer | Sealing Layer | | | | log (on/ofl) | Hysteresis (V) |
| | | Type | Type | SP value (Fedors) | Relative Permittivity | Average Thickness (nm) | | |
| Ex. 1 | 2 | APrES | polystyrene | 10.5 | 2.5 | 500 | 6.7 | 1.6 |
| Ex. 2 | 2 | APrES | CYTOP | 8.7 | 2.0 | 1200 | 6.8 | 0.2 |
| Ex. 3 | 2 | APrES | CYTOP | 8.7 | 2.0 | 500 | 6.8 | 0.8 |
| Ex. 4 | 2 | APrES | poly(methyl methacrylate) | 9.9 | 2.8 | 500 | 6.3 | 1.4 |
| Ex. 5 | 2 | MTMS | polystyrene | 10.5 | 2.5 | 500 | 6.7 | 2.0 |
| Ex. 6 | 2 | KBM-603 | CYTOP | 8.7 | 2.0 | 1200 | 6.8 | 0.6 |
| Ex. 7 | 2 | APrES | polyvinyl chloride | 11.0 | 3.0 | 500 | 6.3 | 2.5 |
| Ex. 8 | 2 | APTES | polyvinylpyrrolidone | 13.4 | 3.5 | 500 | 6.1 | 2.9 |
| Ex. 9 | 2 | APrES | polyvinyl alcohol | 14.6 | 5.0 | 500 | 6.2 | 6.1 |
| Comp. Ex. 1 | 6 | APTES | none | - | - | --- | 2.5 | - |
| Comp. Ex. 2 | 6 | APrES | CYTOP | 8.7 | 2.0 | 1200 | 1.8 | - |
| Comp. Ex. 3 | 6 | APrES | polystyrene | 10.5 | 2.5 | 500 | 2.1 | - |
| Comp. Ex. 4 | 2 | APTES | none | - | - | - | 6.0 | 11.9 |

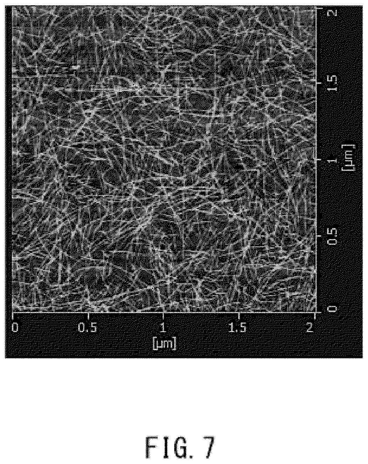

FIG. 7 shows an atomic force micrograph of the semiconductor layer constituting the semiconductor element according to Example 1. As shown in FIG. 7, it can be confirmed that the semiconductor layers had a CNT network structure.

As shown in Table 1, the semiconductor layers of Examples 1 to 9 had an average thickness of 5 nm or less, and thus had ON/OFF ratios that were significantly larger than those of the semiconductor elements of Comparative Examples 1 to 3. Also, a comparison with Comparative Example 4 shows that, even when a sealing layer was formed in Examples, the ON/OFF ratio did not decrease. In this manner, the semiconductor elements of Examples each had a large ON/OFF ratio, and a small hysteresis.

Industrial Applicability

As described above, according to the semiconductor element of the present disclosure and a method for manufacturing the same, it is possible to improve the ON/OFF ratio and reduce hysteresis, which can contribute to improving the performance of devices in which this semiconductor element is used.

Description of Reference Numerals

1    Semiconductor element
2    Semiconductor substrate (gate electrode)
3    Source electrode
4    Drain electrode
5    Semiconductor layer
6    Gate insulating layer
8    Sealing layer
9    Adsorption layer
15   Coating film
50   Carbon nanotube

**Claims**

1. A semiconductor element comprising:

    a gate electrode;
    a source electrode;
    a drain electrode;
    a semiconductor layer that is in contact with the source electrode and the drain electrode; and
    a gate insulating layer that insulates the semiconductor layer from the gate electrode,
    wherein the semiconductor layer has a network structure of carbon nanotubes,
    the semiconductor layer is sealed with a sealing layer, and
    the semiconductor layer has an average thickness of 5 nm or less.

2. The semiconductor element according to claim 1,
    wherein the sealing layer contains a compound whose SP value calculated using the Fedors method is 15 $(cal/cm^3)^{1/2}$ or less.

3. The semiconductor element according to claim 1 or 2,
    wherein the sealing layer has a relative permittivity of 5.0 or less.

4. The semiconductor element according to any one of claims 1 to 3,
    wherein the sealing layer contains one or more selected from the group consisting of a fluorine-based resin, an acrylic resin, a styrene-based resin, a vinyl-based resin, and an olefin-based resin.

5. The semiconductor element according to any one of claims 1 to 4,
    wherein the sealing layer has an average thickness of 200 nm or more.

**6.** The semiconductor element according to any one of claims 1 to 5, further comprising

an adsorption layer that is disposed between the semiconductor layer and the gate insulating film and is in contact with the semiconductor layer and the gate insulating film,
wherein the adsorption layer contains a compound that does not have an anionic group.

**7.** The semiconductor element according to any one of claims 1 to 6,
wherein the carbon nanotubes are single-walled carbon nanotubes.

**8.** The semiconductor element according to any one of claims 1 to 7,
wherein a density of the carbon nanotubes in the network structure is 100 carbon nanotubes/$\mu$m$^2$ or more and 8000 carbon nanotubes/$\mu$m$^2$ or less.

**9.** The semiconductor element according to any one of claims 1 to 8,
wherein an average length of the carbon nanotubes in the network structure is shorter than a channel length of the semiconductor element.

**10.** The semiconductor element according to any one of claims 1 to 9,
wherein the content of semiconducting carbon nanotubes in the carbon nanotubes contained in the semiconductor layer is 70% by mass or more.

**11.** The semiconductor element according to any one of claims 1 to 10,
wherein the semiconductor element is a p-type field-effect transistor.

**12.** A method for manufacturing a semiconductor element,
the semiconductor element including a gate electrode, a source electrode, a drain electrode, a semiconductor layer that is in contact with the source electrode and the drain electrode, and a gate insulating layer that insulates the semiconductor layer from the gate electrode, the method comprising:

forming, using a carbon nanotube dispersion liquid, a semiconductor layer having a network structure of carbon nanotubes and having an average thickness of 5 nm or less; and
forming a sealing layer that seals the semiconductor layer.

**13.** The method for manufacturing a semiconductor element according to claim 12,
wherein a concentration of carbon nanotubes in the carbon nanotube dispersion liquid is 0.1 $\mu$g/mL or more and 7.0 $\mu$g/mL or less.

**14.** The method for manufacturing a semiconductor element according to claim 12 or 13,

wherein, in the forming the semiconductor layer,
the semiconductor layer is formed by forming a coating film by applying the carbon nanotube dispersion liquid, causing the carbon nanotubes to be adsorbed onto a surface to be coated, removing excess carbon nanotubes from the undried coating film, and performing drying treatment.

**15.** The method for manufacturing a semiconductor element according to claim 14,
wherein the excess carbon nanotubes are removed through cleaning using a cleaning liquid.

**16.** The method for manufacturing a semiconductor element according to claim 14 or 15,
wherein the excess carbon nanotubes are removed by immersing the coating film in a cleaning liquid.

**17.** The method for manufacturing a semiconductor element according to any one of claims 12 to 16, further comprising adjusting the carbon nanotube dispersion liquid containing an acrylic acid-based resin.

FIG. 1

EP 4 443 520 A1

FIG. 2

FIG. 3

FIG. 4

FIG. 5A

FIG. 5B

FIG. 5C

FIG. 6A

FIG. 6B

FIG. 6C

FIG. 7

FIG. 8

# INTERNATIONAL SEARCH REPORT

| International application No. |
| --- |
| **PCT/JP2022/030645** |

## A. CLASSIFICATION OF SUBJECT MATTER

*H01L 29/786*(2006.01)i; *H01L 21/336*(2006.01)i; *H01L 29/16*(2006.01)i; *H01L 51/05*(2006.01)i; *H01L 51/30*(2006.01)i
FI:  H01L29/78 618B; H01L29/16; H01L29/28 100A; H01L29/28 250E; H01L29/28 280; H01L29/78 618A; H01L29/78 619A

According to International Patent Classification (IPC) or to both national classification and IPC

## B. FIELDS SEARCHED

Minimum documentation searched (classification system followed by classification symbols)

H01L29/786; H01L21/336; H01L29/16; H01L51/05; H01L51/30

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
| --- | --- | --- |
| X | WO 2018/180146 A1 (TORAY INDUSTRIES, INC) 04 October 2018 (2018-10-04) paragraphs [0018]-[0128], [0161]-[0172], [0194]-[0235], fig. 2, 4, 6-8 | 1-5, 7-13 |
| Y | paragraphs [0018]-[0128], [0161]-[0172], [0194]-[0235], fig. 2, 4, 6-8 | 17 |
| A | paragraphs [0018]-[0128], [0161]-[0172], [0194]-[0235], fig. 2, 4, 6-8 | 6, 14-16 |
| Y | JP 2011-126727 A (TORAY INDUSTRIES, INC) 30 June 2011 (2011-06-30) paragraph [0034] | 17 |
| A | US 2017/0323930 A1 (ZHAO et al.) 09 November 2017 (2017-11-09) entire text, all drawings | 1-17 |

☐ Further documents are listed in the continuation of Box C.  ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **17 October 2022** | **25 October 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

| INTERNATIONAL SEARCH REPORT | | | International application No. |
|---|---|---|---|
| Information on patent family members | | | **PCT/JP2022/030645** |

| Patent document cited in search report | Publication date (day/month/year) | Patent family member(s) | Publication date (day/month/year) |
|---|---|---|---|
| WO 2018/180146 A1 | 04 October 2018 | EP 3605591 A1<br>paragraphs [0018]-[0115],<br>[0148]-[0159], [0180]-[0221],<br>fig. 2, 4, 6-8<br>US 2020/0035925 A1<br>KR 10-2019-0105128 A<br>CN 110402483 A<br>TW 201903850 A | |
| JP 2011-126727 A | 30 June 2011 | (Family: none) | |
| US 2017/0323930 A1 | 09 November 2017 | US 2019/0088722 A1<br>entire text, all drawings | |

Form PCT/ISA/210 (patent family annex) (January 2015)

**REFERENCES CITED IN THE DESCRIPTION**

**Patent documents cited in the description**

- WO 2019066074 A
- JP 2008071898 A
- JP 2008053607 A
- JP 2021080121 A
- JP 2021080120 A
- JP 2021080119 A
- JP 2019202912 A

**Non-patent literature cited in the description**

- *Appl. Master. Interface,* 2014, vol. 6, 8441
- *Nano Lett.,* 2003, vol. 3, 193